Europäisches Patentamt

European Patent Office

Office européen des brevets

(11) Veröffentlichungsnummer: **0 220 471 B1**

(12) **EUROPÄISCHE PATENTSCHRIFT**

(45) Veröffentlichungstag der Patentschrift: 27.03.91

(51) Int. Cl.⁵: **G03B 41/00**, G03F 1/00

(21) Anmeldenummer: 86112874.2

(22) Anmeldetag: 18.09.86

Die Akte enthält technische Angaben, die nach
dem Eingang der Anmeldung eingereicht wurden
und die nicht in dieser Patentschrift enthalten sind.

(54) **Verfahren zur Defektprüfung an Masken.**

(30) Priorität: 08.10.85 DE 3535907

(43) Veröffentlichungstag der Anmeldung:
06.05.87 Patentblatt 87/19

(45) Bekanntmachung des Hinweises auf die
Patenterteilung:
27.03.91 Patentblatt 91/13

(84) Benannte Vertragsstaaten:
DE FR GB

(56) Entgegenhaltungen:
DE-A- 2 848 253

PATENTS ABSTRACTS OF JAPAN, Band 6,
Nr. 104 (P-122)[982], 15. Juni 1982; & JP-A-57
34 555

PATENTS ABSTRACTS OF JAPAN, Band 9,
Nr. 227 (P-388)[1950], 13. September 1985; &
JP-A-60 83 941

SOLID STATE TECHNOLOGY, Band 19, Nr. 4,
April 1976, Seiten 85-86; P. ROSENTHAL: "A
projection system for inspecting wafers, integrated circuits and photomasks"

IBM TECHNICAL DISCLOSURE BULLETIN,
Band 16, Nr. 9, Februar 1976, Seiten
3121-3122, New York, US; R. FEDER:
"Ultrafine line projection system"

PATENTS ABSTRACTS OF JAPAN, Band 7,
Nr. 45 (E-160)[1190], 23. Februar 1983; & JP-
A-57 194 528

(73) Patentinhaber: Siemens Aktiengesellschaft
Wittelsbacherplatz 2
W-8000 München 2(DE)

(72) Erfinder: Doemens, Günter, Dr.
Föchingerstrasse 4
W-8150 Holzkirchen(DE)

Anmerkung: Innerhalb von neun Monaten nach der Bekanntmachung des Hinweises auf die Erteilung des
europäischen Patents kann jedermann beim Europäischen Patentamt gegen das erteilte europäische Patent
Einspruch einlegen. Der Einspruch ist schriftlich einzureichen und zu begründen. Er gilt erst als eingelegt, wenn
die Einspruchsgebühr entrichtet worden ist (Art. 99(1) Europäisches Patentübereinkommen).

**Beschreibung**

Die Erfindung betrifft ein Verfahren zur Defektprüfung an Masken mit Submikrometerstrukturen, insbesondere an Masken für die Röntgenlithografie.

In der Halbleitertechnologie wird die Erzeugung von Strukturen auf Halbleiterscheiben auf fotolithgografischen Wege vorgenommen, wobei nacheinander die Strukturen verschiedener Masken auf die Halbleiterscheiben übertragen werden. Voraussetzung für einwandfreie Strukturen auf den Halbleiterscheiben ist jedoch die Verwendung absolut defektfreier Masken, d. h. die Masken müssen vor ihrem Einsatz einer Defektprüfung unterzogen werden. Bei den in der Halbleitertechnologie üblichen Masken mit Strukturen im Mikrometerbereich wird diese Defektprüfung als visuelle oder automatische Sichtprüfung über lichtoptische Mikroskope vorgenommen. Geeignete Verfahren und Vorrichtungen für eine opto-elektronische Defektprüfung an Masken mit Mikrometerstrukturen sind beispielsweise aus der DE-OS 29 29 846 oder der DE-OS 29 37 741 bekannt.

Die Röntgenlithografie erlaubt die Erzeugung von Strukturen mit Abmessungen deutlich unter einem Mikrometer. Dabei wird die Struktur einer als Absorbermaske wirkenden Maske im Schattenwurfverfahren auf die Halbleiterscheibe übertragen, wobei natürlich auch hier wieder die Verwendung einer absolut defektfreien Maske Voraussetzung für eine einwandfreie Struktur auf der Halbleiterscheibe ist. Eine visuelle oder automatische Sichtprüfung über lichtoptische Mikroskope scheidet bei Masken mit Submikrometerstrukturen jedoch aufgrund der begrenzten Auflösung durch die Lichtwellenlänge aus. Eine Prüfung der Masken mit Elektronenstrahlen und die daraus resultierenden Bilder der Maskenstrukturen würden keinen hinreichenden Aufschluß über die lokalen Absorptionseigenschaften der Masken für die bei der Strukturübertragung verwendete Röntgenstrahlung geben.

Der Erfindung liegt die Aufgabe zugrunde, ein Verfahren zur Defektprüfung an Masken mit Submikrometerstrukturen, insbesondere an Masken für die Röntgenlithografie zu schaffen, mit welchem auch kleinste Defekte der Masken erfaßt werden können.

Diese Aufgabe wird erfindungsgemäß dadurch gelöst, daß die Submikrometerstrukturen einer zu prüfenden Maske vergrößert auf einen Bildträger abgebildet werden, wobei ein derartiger Abbildungsmaßstab gewählt wird, daß die vergrößerten Strukturen auf dem Bildträger einer visuellen oder automatischen Sichtprüfung unterzogen werden können. Es wird also vorgeschlagen, beliebige Masken mit Submikrometerstrukturen in die Dimensionen zurückzuvergrößern, die einer visuellen oder automatischen Inspektion über Lichtmikroskope nach bekannten Verfahren zugänglich sind.

Das erfindungsgemäße Verfahren eignet sich insbesondere zur Defektprüfung an Masken für die Röntgenlithografie. Gemäß einer bevorzugten Ausgestaltung der Erfindung werden die Submikrometerstrukturen einer zu prüfenden Maske für die Röntgenlithografie mit Hilfe von Röntgenstrahlen vergrößert auf den mit einem röntgenempfindlichen Resist beschichteten Bildträger abgebildet. Nach der Entwicklung des belichteten Bildträgers liegt dann die vergrößerte Struktur der Maske mit Submikrometerstrukturen entsprechend deren lokalen Absorption für Röntgenstrahlung vor.

Im Hinblick auf die besonderen Eigenschaften von Röntgenstrahlen und auf die Schwierigkeiten einer Abbildung mit Röntgenstrahlen ist es besonders günstig, wenn die Submikrometerstrukturen der Maske durch Zentralprojektion mit einer punktförmigen Röntgenstrahlquelle auf den Bildträger abgebildet werden.

Um die Bedingungen bei der Defektprüfung den bei der Strukturübertragung herrschenden Bedingungen noch besser anzupassen ist es auch vorteilhaft eine Röntgenstrahlquelle zu verwenden, deren Wellenlänge zumindest annähernd der Wellenlänge der beim Einsatz der Maske für die Strukturübertragung verwendeten Röntgenstrahlung entspricht.

Ein Ausführungsbeispiel der Erfindung ist in der Zeichnung dargestellt und wird im folgenden näher erläutert.

Es zeigen

Figur 1     in stark vereinfachter schematischer Darstellung das Prinzip der vergrößerten Abbildung der Submikrometerstrukturen einer Maske für die Röntgenlithografie auf einen Bildträger und

Figur 2     ebenfalls in stark vereinfachter schematischer Darstellung das Prinzip der automatischen Sichtprüfung der auf dem Bildträger vergrößert abgebildeten Submikrometerstrukturen der Maske.

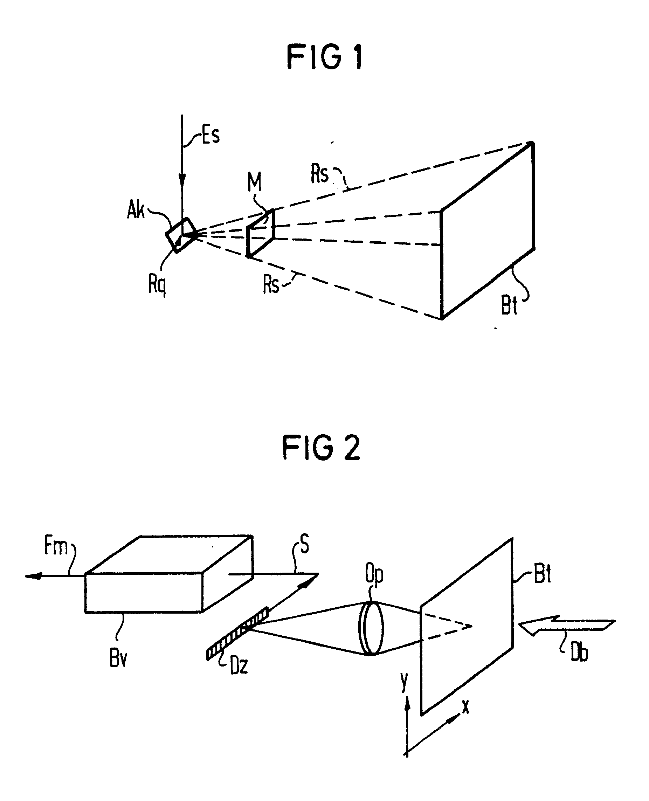

Figur 1 zeigt von einer sonst nicht näher dargestellten Röntgenröhre einen Elektronenstrahl Es, der auf eine als Antikathode Ak bezeichnete schräggestellte Anode auftrifft. Der Auftreffpunkt des Elektronenstrahls Es auf die Antikathode Ak stellt eine Röntgenstrahlquelle Rq dar, die möglichst punktförmig sein soll und auch als Mikrofokusröntgenquelle bezeichnet werden kann. Durch die von der Röntgenstrahlquelle Rs ausgehenden Röntgenstrahlen Rs werden die nicht näher dargestellten Submikrometerstrukturen einer Maske M für die Röntgenlithografie durch Zentralprojektion vergrößert auf einen Bildträger Bt abgebildet. Bei dem Bildträger Bt handelt es sich um ein Glassubstrat auf welches als Lack ein für Röntgenstrahlung höchstempfindlicher Resist aufgetragen ist. Die Verwendung eines üblicherweise wegen schlechter Prozeßverträglichkeit nicht eingesetzten höchstempfindlichen Resists ist hier sinnvoll, um die Belichtungszeiten für die Rückvergrößerung zu minimieren.

Die Wellenlänge der von der Röntgenstrahlquelle Rq ausgehenden Röntgenstrahlung soll möglichst nahe bei der Wellenlänge der für die Strukturübertragung mit der Maske M verwendeten Röntgenstrahlung liegen. Nach der Entwicklung des belichteten Bildträgers Bt liegt dann die vergrößerte Struktur der Maske M mit Submikrometerstrukturen entsprechend deren lokalen Absorption für Röntgenstrahlung vor. Bei der Rückvergrößerung der Submikrometerstrukturen mit Abmessungen von beispielsweise 0,4 um wird ein derartiger Abbildungsmaßstab gewählt, daß die vergrößerten Strukturen mit Abmessungen von beispielsweise 2 um anschließend einer visuellen oder automatischen Sichtprüfung unterzogen werden können.

Gemäß Figur 2 wird zur Defektprüfung der in Figur 1 dargestellten Maske M der Bildträger Bt mit den vergrößer ten Strukturen einer automatischen Sichtprüfung unterzogen. Die vergrößerten Strukturen des Bildträgers Bt werden mittels einer durch einen Pfeil Db angedeuteten Durchlichtbeleuchtung über eine Optik Op auf einen Bildwandler abgebildet, bei welchem es sich im dargestellten Ausführungsbeispiel um eine Diodenzeile Dz handelt. Das Signal S der Diodenzeile Dz wird einer mit Bv bezeichneten Bildverarbeitung zugeführt, welche beim Vorliegen eines Defekts der Maske M (vgl. Fig. 1) eine entsprechende Fehlermeldung Fm ausgibt. Dem Bildträger Bt ist ein kartesisches x, y-Koordinatensystem zugeordnet, so daß mit einer Fehlermeldung Fm auch die Koordinaten eines entsprechenden Defekts angegeben werden können.

Die in Figur 2 rein schematisch aufgezeigte automatische Sichtprüfung eines Bildträgers Bt kann beispielsweise mit einem aus der DE-OS 29 29 848 oder der US-PS 4 305 097 bekannten optoelektronischen Prüfsystem zur automatischen Beschaffenheitsprüfung vorgenommen werden. Dabei wird der Bildträger Bt auf einem Kreuztisch angeordnet und mäanderförmig mit konstanter Geschwindigkeit relativ zur Diodenzeile Dz bewegt, wobei die x, y-Koordinaten durch ein Wegmeßsystem erfaßt werden. Die Bildverarbeitung Bv umfaßt eine analoge Signalvorverarbeitung, an welche sich mehrere parallel arbeitende Fehlererkennungsschaltungen anschließen. Nach einem vollständigen Durchlauf des Prüflings können eventuell erfaßte Defekte neu angefahren und über eine Betrachtungseinrichtung vergrößert sichtbar gemacht werden.

Das erfindungsgemäße Verfahren ermöglicht eine Defektprüfung an beliebigen Masken mit Submikrometerstrukturen. Die Submikrometerstrukturen werden dabei in die Dimensionen zurückvergrößert, die einer visuellen oder auto matischen Inspektion über Lichtmikroskope nach bekannten Verfahren zugänglich sind.

## Ansprüche

1. Verfahren zur Defektprüfung an Masken mit Submikrometerstrukturen, insbesondere an Masken für die Röntgenlithografie, **dadurch gekennzeichnet**, daß die Submikrometerstrukturen einer zu prüfenden Maske (M) vergrößert auf einen Bildträger (Bt) abgebildet werden, wobei ein derartiger Abbildungsmaßstab gewählt wird, daß die vergrößerten Strukturen auf dem Bildträger (Bt) anschließend einer visuellen oder automatischen Sichtprüfung unterzogen werden können.

2. Verfahren nach Anspruch 1, dadurch **gekennzeichnet**, daß die submikrometerstrukturen einer zu prüfenden Maske (M) für die Röntgenlithografie mit Hilfe von Röntgenstrahlen (Rs) vergrößert auf den mit einem rötgenempfindlichen Resist beschichteten Bildträger (Bt) angebildet werden.

3. Verfahren nach Anspruch 2, dadurch **gekennzeichnet**, daß die Submikrometerstrukturen der Maske (M) durch Zentralprojektion mit einer punktförmigen Röntgenstrahlquelle (Rq) auf den Bildträger (Bt) agbebildet werden.

## Claims

1. Process for examining defects in masks having submicrometre structures, characterised in that the submicrometre structures of a mask (M) to be examined are imaged, enlarged with the aid of X-rays (RS), on an image carrier (St) coated with an X-ray-sensitive resist, in which process an imaging scale of such a type is selected that the enlarged structures on the image carrier (Bt) can be subsequently subjected to a visual or automatic inspection.

2. Process according to Claim 1, characterised in that the submicrometre structures of the mask (M) are imaged on the image carrier (Bt) by central projection by means of a point-shaped X-ray source (Rq).

3. Process according to Claim 2, characterised in that an X-ray source (Rq) is used, the wavelength of which corresponds at least approximately to the wavelength of the X-radiation used when the mask (M) was used for transferring the structure.

**Revendications**

1. Procédé pour le contrôle de masques à structures submicrométriques, caractérisé par le fait que les structures submicrométriques d'un masque (M) à contrôler sont reproduites à plus grande échelle, et à l'aide rayons X, sur un support d'image (Bt) revêtu d'une couche d'un resist sens aux rayons X, l'échelle de reprouction étant choisie de telle manière que les structures agrandies formées sur le support d'image (Bt) peuvent ensuite être soumises à un examen, visuel ou automatique.

2. Procédé selon la revendication 1, caratérisé par le fait que les structures submicrométriques du masque (M) sont reproduites sur l e support d' image (Bt) à l' aide d' une projection centrale avec une source de rayons X ponctuelle (Rq).

3. Procédé selon la revendication 2, caractéisé par le fait que l'on utilise une source de rayons X (Rq) dont la longueur d'onde correspond approximativement au moins à la longueur d' onde du rayonnement X utili sé lors de la mise en oeuvre du masque (M) pour le transfert de la structure.

# FIG 1

# FIG 2